**Europäisches Patentamt**

**European Patent Office**

**Office européen des brevets**

(19)

(11) Veröffentlichungsnummer : **0 071 665**
**B1**

(12) **EUROPÄISCHE PATENTSCHRIFT**

(45) Veröffentlichungstag der Patentschrift :
**16.04.86**

(21) Anmeldenummer : **81106214.0**

(22) Anmeldetag : **08.08.81**

(51) Int. Cl.⁴ : **H 01 L 21/265, H 01 L 21/82**

(54) **Verfahren zum Herstellen einer monolithisch integrierten Festkörperschaltung mit mindestens einem bipolaren Planartransistor.**

(43) Veröffentlichungstag der Anmeldung :
**16.02.83 Patentblatt 83/07**

(45) Bekanntmachung des Hinweises auf die Patenterteilung : **16.04.86 Patentblatt 86/16**

(84) Benannte Vertragsstaaten :
**DE FR GB IT NL**

(56) Entgegenhaltungen :
**EP-A- 0 002 661**
**DE-A- 2 433 839**
**US-A- 4 111 720**

(73) Patentinhaber : **Deutsche ITT Industries GmbH**
**Hans-Bunte-Strasse 19 Postfach 840**
**D-7800 Freiburg (DE)**
**DE**
**ITT INDUSTRIES INC.**
**320 Park Avenue**
**New York, NY 10022 (US)**
**FR GB IT NL**

(72) Erfinder : **Blossfeld, Lothar, Dipl.-Phys.**
**Waldstrasse 23**
**D-7800 Freiburg-Hochdorf (DE)**

(74) Vertreter : **Morstadt, Volker, Dipl.-Ing.**
**c/o Deutsche ITT Industries GmbH Patent/Lizenzabteilung Postfach 840 Hans-Bunte-Strasse 19**
**D-7800 Freiburg/Brsg. (DE)**

## Beschreibung

Die Erfindung beschäftigt sich mit der Herstellung von monolithisch integrierten Festkörperschaltungen hoher Packungsdichte mit Planartransistoren kleinster Abmessungen. Dabei wird ausgegangen von dem aus der DE-OS-30 09 434 und aus der Zeitschrift « Electronics » vom 7. 7. 8. 1975, Seiten 104 bis 106, bekannten Dreifach-Diffusionsverfahren (3D-Technology). Dieses Verfahren zeichnet sich dadurch aus, daß nacheinander in drei Prozessen mittels Ionenimplantation die Dotierungen der Kollektorzone, der Basiszone und der Emitterzone aufgebracht und eindiffundiert werden, so daß drei Diffusionsprozesse aufeinanderfolgen.

Dieses im folgenden als 3D-Verfahren bezeichnete Verfahren hat, abgesehen von der Möglichkeit einer Herstellung von bipolaren integrierten Schaltungen hoher Packungsdichte, den Vorteil, daß die Hochtemperaturprozesse des Aufbringens einer Epitaxialschicht auf eine, gegebenenfalls mit Dotierungsbereichen zur Herstellung von vergrabenen Schichten versehenen Substrats und die Diffusion von Isolationszonen entfallen. Diese zur elektrischen Trennung der einzelnen Transistoren im allgemeinen erforderlichen Hochtemperaturprozesse werden beim 3D-Verfahren durch einen Hochtemperaturprozess, nämlich den Kollektordiffusionsprozess, ersetzt. Es entstehen schließlich Planartransistoren mit ineinander diffundierten Zonen.

Den Nachteil eines Hochtemperaturprozesses, nämlich zum Herstellen einer Epitaxialschicht, weist beispielsweise das bekannte Verfahren der DE-A-24 33 839 auf, bei dem die Dotierungen der Basiszone und die der Emitterzone in die relativ niedrig dotierte Epitaxialschicht auf einem relativ hoch dotierten Substrat, das mit der Epitaxialschicht die Kollektorzone des Transistors bildet, implantiert werden. Gleiches gilt für das Verfahren der EP-A-0 002 661 zum Herstellen von integrierten bipolaren Transistoren, bei welchem Verfahren die Dotierungen der Basiszonen und die der Emitterzonen unter Anwendung der Ionenimplantation in eine Epitaxialschicht eingebracht werden.

Aus der US-A-4 111 720 ist ein Verfahren zum Herstellen einer monolithisch integrierten Festkörperschaltung mit mindestens einem bipolaren Planartransistor bekannt, dessen Emitterzone an einer Oberflächenseite eines halbleitenden Substrats ein eine Basiszone angrenzt, welche in die Kollektorzone eindiffundiert ist. Bei diesem Verfahren werden mittels einer ersten maskierten Ionenimplantation die Dotierungen der Kollektorzone innerhalb eines Kollektorbereichs in die Oberflächenseite eingebracht und dann eine den Basisbereich definierende Photolackmaske erzeugt. Anschließend werden in einem zweiten Ionenimplantationsschritt bei relativ geringer Beschleunigungsenergie und relativ hoher Dosis Dotierungsionen vom Leitungstyp der Basiszone und in einem dritten Ionenimplantationsschritt bei relativ großer Beschleunigungsenergie und relativ geringer Dosis Dotierungsionen des gleichen Leitungstyps in den Basisbereich implantiert. Dann werden die Dotierungen der Emitterzone mittels einer vierten maskierten Ionenimplantation in den Basisbereich eingebracht und in einem weiteren Schritt die in den Basisbereich und die Emitterzone implantierten Dotierungen eindiffundiert. Die Erfindung geht von diesem Verfahren der US-Patentschrift aus.

Das bekannte Verfahren hat den Nachteil, daß die Stromverstärkungswerte der Transistoren, welche bekanntlich in großer Anzahl in einer einzigen die gesamte Festkörperschaltung aufnehmenden Halbleiterplatte hergestellt werden, von Platte zu Platte Schwankungen unterworfen sind.

Die Erfindung geht von der Erkenntnis aus, daß Schwankungen der genannten Stromverstärkungswerte (B-Werte) um wenige Prozent möglich werden, wenn die Herstellungsprozesse derart ausgewählt und geführt werden, daß die Gesamtladungsträgermenge in den intrinsischen Basiszonen, d. h. in dem Bereich der Basiszone unter der Emitterzone, sowohl möglichst exakt steuerbar sind als auch nichtkompensierte Emitterzonen verwendet werden. Eine nichtkompensierte Emitterzone hat nach « International Electron Devices meeting. Technical Digest » (1979) Seiten 514 bis 516, den Vorteil, daß relativ große Stromverstärkungswerte und erhöhte Grenzfrequenzen möglich sind.

Aufgabe der Erfindung ist daher die Angabe eines Herstellungsverfahrens gemäß dem Oberbegriff des Anspruchs 1, welches es erlaubt, die Streuung der Stromverstärkungswerte der Planartransistoren sowohl über die Halbleiterplatten als auch über die einzelnen integrierten Festkörperschaltungen auf einer einzelnen Halbleiterplatte auf ein Minimum zu bringen.

Diese Aufgabe wird erfindungsgemäß durch die im kennzeichnenden Teil des Anspruch 1 angegebenen Maßnahmen gelöst.

Als Material für die Oxidationsmaskierungsschicht wird vorzugsweise Siliciumnitrid oder auch eine mit einer Siliciumnitridschicht abgedeckte Schicht aus Siliciumdioxid verwendet. In diesem Fall eignet sich als Material für die Ätzmaskierungsschicht, mit der der äußere Basisbereich abgedeckt wird, eine Schicht aus Siliciumdioxid, welches beispielsweise durch die als Ätzmittel von Siliciumnitrid bekannte heiße Phosphorsäure praktisch nicht ätzbar ist.

Es ist besonders vorteilhaft, in die Ätzmaskierungsschicht eine Kontaktierungsschicht aus dotiertem polykristallinen Silicium einzubetten, welche die Basiszone oberflächlich kontaktiert und daher als Zuleitung oder auch als Widerstand zur Basiszone verwendet werden kann.

Eine besondere Weiterbildung des Verfahrens nach der Erfindung beschäftigt sich mit dem Problem der Kompatibilität mit dem bekannten

Silicon-Gate-Prozeß zum Herstellen von integrierten Si-Gate-Feldeffekttransistoren in der gleichen Halbleiterplatte und daher mit der Herstellung von monolithisch integrierten Festkörperschaltungen, die neben bipolaren Transistoren Si-Gate-Feldeffekttransistoren enthalten.

Das Verfahren nach der Erfindung und ihre Vorteile wird im folgenden an Ausführungsbeispielen erklärt, welche anhand der Zeichnung erläutert werden, deren Fig. 1 bis 8 in üblicher Darstellung ausschnittsweise Querschnittansichten etwa senkrecht zur Hauptfläche eines plattenförmigen Substrats einer monolithisch integrierten Festkörperschaltung zeigen, welche zur Erläuterung eines ersten Ausführungsbeispiels des Verfahrens nach der Erfindung dienen, deren Fig. 9 bis 14 zur Erläuterung eines zweiten Ausführungsbeispiels nach der Erfindung herangezogen werden und deren Fig. 15 in gleicher Teilschnittdarstellung einen monolithisch integrierten Planartransistor zeigt, der entsprechend einer Weiterbildung des Verfahrens nach der Erfindung dargestellt wurde.

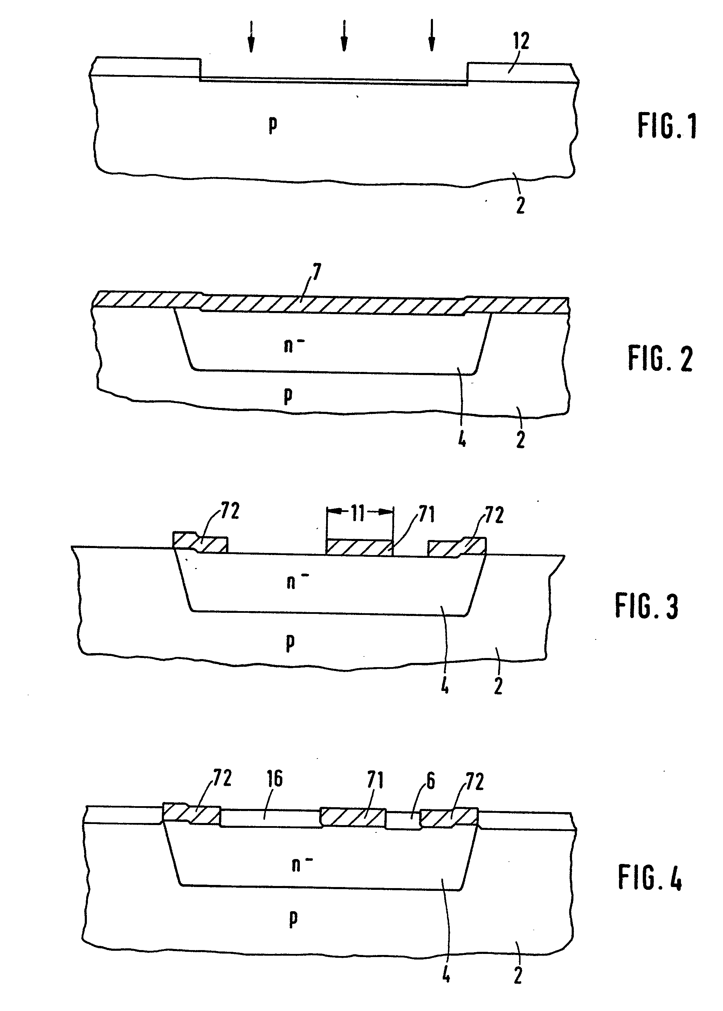

Bei dem ersten Ausführungsbeispiel des Verfahrens nach der Erfindung kann gemäß der Fig. 1 von einem p-dotierten plattenförmigen Siliciumsubstrat geringer Dotierung mit einem spezifischen Widerstand zwischen 1 und 100 Ohm · cm ausgegangen werden, welches mit einer thermisch gewachsenen Oxidmaske 12 bedeckt wird und einem Implantationsprozeß geringer Dosis im Bereich von $10^{12}$ bis $10^{14}$ $cm^{-2}$ ausgesetzt wird.

Anschließend erfolgt in oxidierender Atmosphäre ein Diffusionsprozeß, bei dem die Kollektorzone 4 entsteht. Die Hauptfläche wird freigelegt und die Oxidationsmaskierungsschicht 7 aus Siliciumnitrid aufgebracht. Anstelle einer Siliciumnitridschicht 7 kann auch eine Mehrschichtenstruktur mit oben liegender Siliciumnitridschicht verwendet werden. Jedenfalls ist die Wahl der Materialien so zu treffen, daß die Oxidationsmaskierungsschicht 7 selektiv gegenüber der später noch aufzubringenden Ätzmaskierungsschicht 6 (vgl. Fig. 4) ätzbar ist.

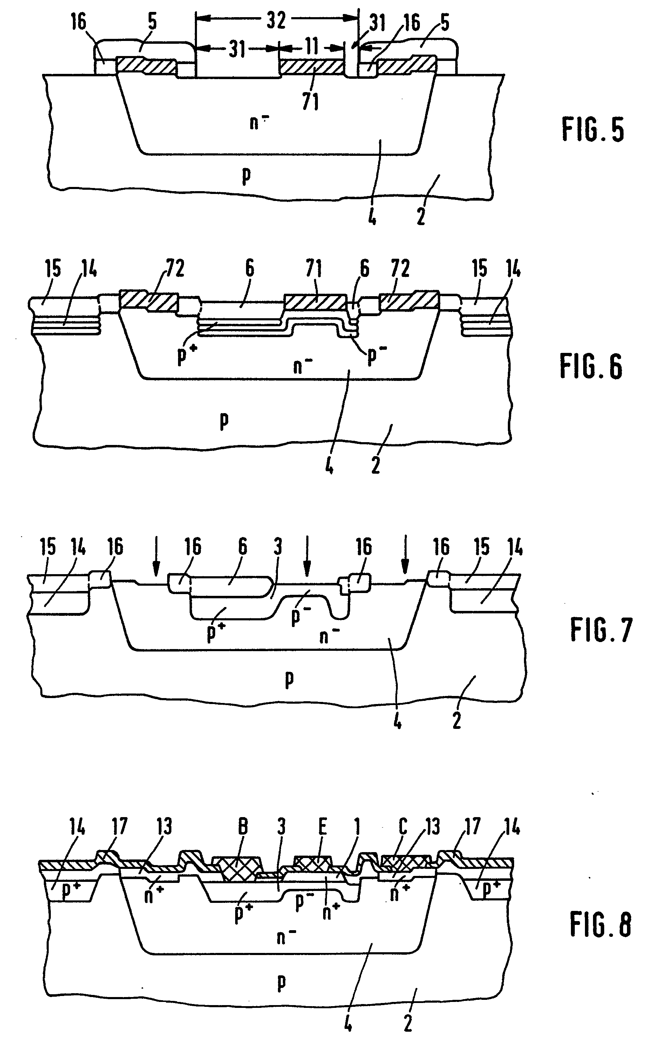

Aus dieser Oxidationsmaskierungsschicht 7 werden Oxidationsmaskierungsschichtteile 71 und 72 herausgeätzt, wovon der Oxidationsmaskierungsschichtteil 71 den Emitterbereich 11 und der Schichtteil 72 den Bereich der Kollektorkontaktzone 13 (Fig. 8) abdeckt.

Durch einen thermischen Oxidationsprozeß wird anschließend gemäß der Fig. 4 die Ätzmaskierungsschicht 6 aus $SiO_2$ aufgebracht, welche bei dem später erfolgenden Ätzprozeß zur Entfernung der aus Siliciumnitrid bestehenden Oxidationsmaskierungsschichtteilen 71 und 72 erhalten bleibt.

Danach wird gemäß der Fig. 5 die Photolackmaske 5 aufgebracht, welche den Basisbereich 32 ausspart. Bei dem Ausführungsbeispiel endet die Photolackmaske 5 jenseits des pn-Übergangs zwischen der Kollektorzone 4 und dem Substrat 2, so daß bei den anschließend erfolgenden Implantationsprozessen von p-dotierten Verunreinigungen außerhalb der Kollektorzone 4 eine diese rahmenförmig umgebende Kanalstopperzone 14 entsteht, wie die Fig. 6 veranschaulicht.

Die Implantation der Dotierungsionen vom Leitungstyp der Basiszone 3, bei der die Anordnung gemäß der Fig. 6 erhalten wird, erfolgt in zwei Schritten beliebiger Reihenfolge. Dabei werden das eine Mal, abgesehen von der Implantation in dem Bereich der Kanalstopperzone 14, bei relativ geringer Beschleunigungsenergie Dotierungsionen in den freiliegenden äußeren Basisbereich 31 außerhalb des Emitterbereiches 11 und das andere Mal bei relativ großer Beschleunigungsenergie, welche ausreicht den Oxidationsmaskierungsschichtteil 71 zu durchdringen, Dotierungsionen gleichen Leitungstyps in den gesamten Basisbereich 32 einschließlich des Emitterbereichs 11 implantiert. Vorzugsweise erfolgt die Implantation hoher Energie mit geringer Dosis von ca. $10^{12}$ bis $10^{13}$ $cm^{-2}$ und die Implantation relativ geringer Energie bei demgegenüber wesentlich erhöhter Dosis, um einen niedrigen intrinsischen Basiswiderstand zu erhalten.

Anschließend wird, nachdem der extrinsische Basisteil 31 mit der Maskierungsschicht 6 und 15 versehen worden ist, das Halbleitersubstrat einem selektiv Siliciumnitrid angreifenden Ätzmittel, insbesondere heißer Phosphorsäure, ausgesetzt und die Oxidationsmaskierungsschichtteile 71 und 72 entfernt, wie die Fig. 7 veranschaulicht.

Anschließend werden in die Oberfläche n-dotierende Verunreinigungen vom Leitungstyp der Emitterzone implantiert, wobei die Ätzmaskierungsschicht 6, die gleichzeitig erzeugten Oxidschichtteile 15 und die von der Photolackmaske 5 abgedeckten Teile der thermisch erzeugten Oxidschicht 16 als gegen die Implantation wirksame Maske verwendet werden. Es wird eine Implantation von n-dotierenden Ionen in einer relativ hohen Dosis von $10^{15}$ bis $10^{16}$ durchgeführt um einen hohen Emitterwirkungsgrad und eine niederohmige Kollektoranschlußzone 14 zu erhalten.

Nach der Implantation wird die gesamte Anordnung mit einer Fremdoxidschicht 17 abgedeckt und sowohl die Basiszonendiffusion als auch die Emitterdiffusion unter Aktivierung der Dotierungen gleichzeitig unter dieser Fremdoxidschicht 17 durchgeführt.

Nach Anbringung des Emitterkontakts E, des Basiskontakts B und des Kollektorkontakts C wird der monolithisch integrierte Planartransistor gemäß der Fig. 8 erhalten.

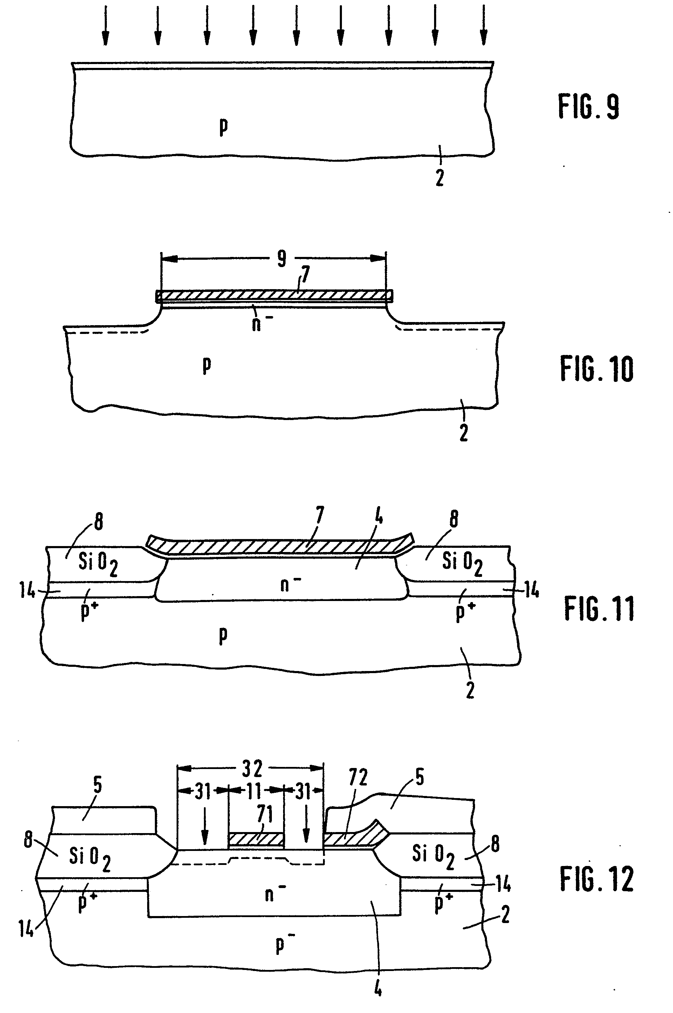

Obwohl mit dem Verfahren nach der Erfindung auch PNP-Planartransistoren herstellbar sind, wird im Hinblick auf eine große Grenzfrequenz das Verfahren der Erfindung natürlich hauptsächlich bei der Herstellung von NPN-Planartransistoren angewendet und von einem p-dotierten Substrat ausgegangen, wie es bei dem im folgenden erläuterten zweiten Ausführungsbeispiel der Fig. 9 bis 14 der Fall ist. Bei diesem Ausführungsbeispiel wird die Kollektorzone 4 nicht unter Anwendung einer maskierten Implantation, sondern durch einen Ätzprozess nach der Implantation über die eine Hauptfläche des plattenförmigen Substrats 2 hergestellt. Bei diesem zweiten Ausführungsbeispiel wird vor der Diffusion der Kollektorzone 4 der Kollektorbereich 9 des Substrats 2 aus Silicium gemäß der Fig. 10 mit einer Oxidationsmaskierungsschicht 7 bedeckt.

Zu diesem Zwecke wird gemäß der Fig. 9 von einem relativ hochohmigen p-dotierten plattenförmigen Substrat 2 ausgegangen und in die gesamte eine Hauptfläche n-dotierende Ionen implantiert, wie die Fig. 9 veranschaulicht. Die gesamte Hauptfläche wird mit einer Schicht aus dem Material der Oxidationsmaskierungsschicht 7 bedeckt und daraus die Maskierungsschicht 7 herausgeätzt. Danach wird das Substrat 2 um den Kollektorbereich 9 unter Verwendung der Oxidationsmaskierungsschicht 7 als Ätzmaske unter Verwendung eines das Substrat 2 selektiv angreifenden Ätzmittels abgetragen, wie die Fig. 10 zeigt. In die freiliegende Substratoberfläche können zur Herstellung einer die Kollektorzone 4 umgebenden Zone 14, welche eine unerwünschte Leitkanalbildung verhindern soll, Ionen vom Leitungstyps des Substrats 2 implantiert werden, was durch die gestrichelte Linie in Fig. 10 angedeutet worden ist.

Schließlich erfolgt eine thermische Oxidation zur Ausbildung der dicken Oxidschicht 8 gemäß der Fig. 11, bei der bereits die einen unerwünschten Leitkanal verhindernde Zone 14 teilweise ausgebildet worden ist.

Anschließend wird, wie die Fig. 12 zeigt, aus der Oxidationsmaskierungsschicht 7 der den Emitterbereich 11 abdeckende Oxidationsmaskierungsschichtteil 71 herausgeätzt und die Photolackmaske 5 aufgebracht, die insofern den Basisbereich 32 definiert, als auch der Rand der Dickoxidschicht 8 zur Begrenzung mit herangezogen wird.

Es erfolgen nun in beliebiger Reihenfolge die beiden Implantationsprozesse unterschiedlicher Beschleunigungsenergie und Dosis von Ionen des Leitungstyps der Basiszone, wie in der Fig. 12 durch die gestrichelten Linien angedeutet worden ist.

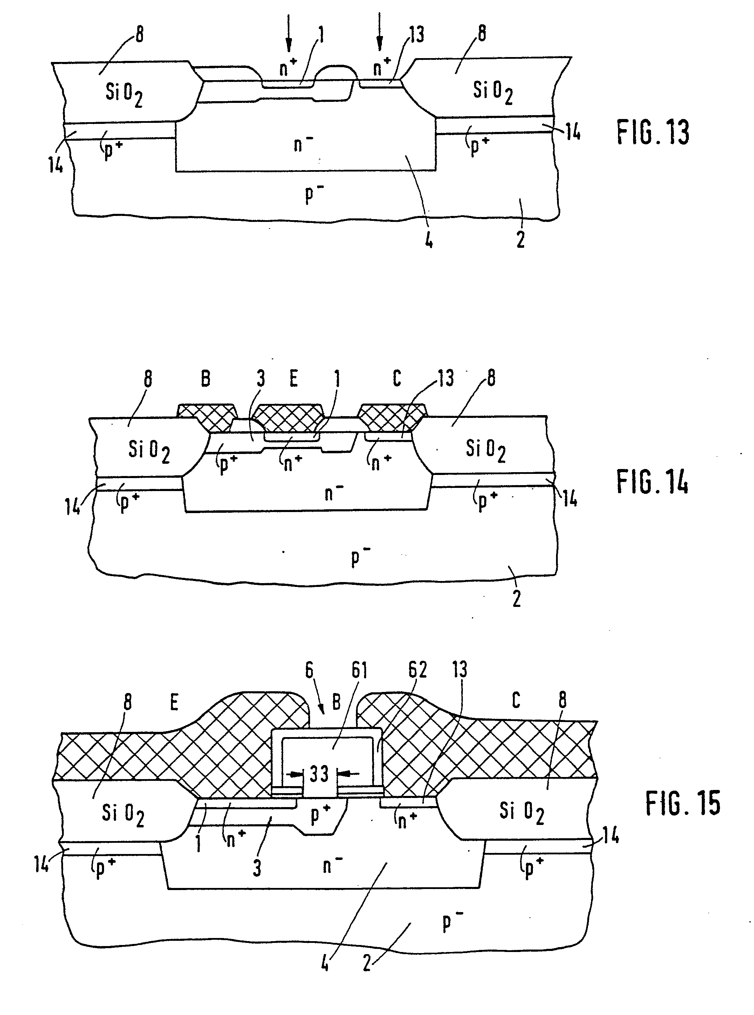

Nach der selektiven Entfernung der Oxidationsmaskierungsschichtteilen 71 und 72 erfolgt die Implantation der Dotierungen der Emitterzone 1 und die der Kollektorkontaktierungszone 13 gemäß der Fig. 13, welche die Anordnung nach einer Aktivierung der Ionen zeigt. Schließlich werden der Basiskontakt B, der Emitterkontakt E und der Kollektorkontakt C entsprechend der Fig. 14 angebracht.

Die Möglichkeit, das Verfahren nach der Erfindung mit der Si-Gate-Technologie kompatibel zu gestalten, ergibt sich entsprechend einer Weiterbildung des Verfahrens nach der Erfindung dadurch, daß bei dem anhand der Fig. 9 bis 14 beschriebenen zweiten Ausführungbeispiel der Oxidationsmaskierungsschichtteil 71 derart ausgeätzt wird, daß sein Rand teilweise entlang des Randes des Dickoxids 8 verläuft. In diesem Falle ergibt sich eine Emitterzone 1, welche an einem Teil ihres Umfangs an das Dickoxid 8, welches tiefer in das Substrat 2 als die Emitterzone 1 eindringt, angrenzt. Es wird schließlich ein integrierter Planartransistor gemäß der Fig. 15 erhalten, dessen Basiselektrode B zwischen der Emitterelektrode E und der Kollektorelektrode C zu liegen kommt.

Integrierte Planartransistor gemäß der Fig. 15 sind im übrigen zur Erläuterung einer Weiterbildung des Verfahrens nach der Erfindung geeignet, bei der in die Ätzmaskierungsschicht eine Kontaktierungsschicht 61 aus dotiertem polykristallinem Silicium eingebettet wird, welche die Basiszone 3 oberflächlich kontaktiert. Zur Herstellung einer solchen Kontaktierungsstruktur wird beispielsweise in einem Verfahrenstadium gemäß der Fig. 10 in der über den Kollektorbereich 9 aufgebrachten Oxidationsmaskierungsschicht 7 eine Kontaktierungsöffnung 33 (Fig. 15) angebracht und anschließend der in Verbindung mit der Fig. 10 erwähnte Implantationsprozess von p-dotierenden Verunreinigungen durchgeführt. Es erfolgt anschließend die Ausbildung der Kontaktierungsschicht 61 unter Anwendung zum Aufdampfens von polykristallinem Silicium und Begrenzung über den Bereich des Kollektorzonenbereichs, der nicht dem Implantationsprozess von n-dotierenden Verunreinigungen auszusetzen ist. Die Dotierung der Kontaktierungsschicht 61 kann vor einer thermischen Oxidation derselben durch einen Implantationsprozess erfolgen. Es wird somit eine Ätzmaskierungsschicht 6 erhalten, die die selektive Entfernung der nichtgezeigten Oxidationsmaskierungsschicht über dem Emitterbereich und über den Kollektorkontaktierungsbereich erlaubt.

Die Schnittansicht gemäß der Fig. 15 eines durch das Verfahren nach der Erfindung hergestellten monolithisch integrierten Planartransistors läßt oberflächlich betrachtet eine gewisse Ähnlichkeit mit einem N-Kanal-Si-Gate-Feldeffekttransistor erkennen. Das Verfahren der Erfindung ist nämlich, zumindest was mit Integration von Si-Gate-Feldeffekttransistoren vom Leitungstyp der Emitterzone des bipolaren Planartransistors betrifft, vollständig kompatibel, da lediglich gewisse Arbeitsprozesse allein auf dem Bereich des bipolaren Planartransistors beschränkt werden müssen. Wird nämlich die Oxidationsmaskierungsschicht bzw. der Oxidationsmaskierungsschichtteil 7 in einer solchen Dicke und Zusammensetzung auf das Substrat 2 aufgebracht, wie es zur Verwendung an einer Si-Gateelektrode eines Si-Gate-Feldeffekttransistors erforderlich ist, der Ätzprozess für die Kontaktierungsöffnung 33 (Fig. 15) im Bereich des Feldeffekttransistors fortgelassen und die Implantation des Dotierungsmaterials der Basiszone 3 im Bereich des Feldeffekttransistors durch eine Photolackmaske maskiert, so wird wie ohne weiteres anhand der Fig. 15 erkennbar ist, der erwähnte N-Kanal-Si-Feldeffekttransistor erhalten. Dabei stellt der Teil der Kontaktierungsschicht 61 zwischen den Zonen 1 und 13 die Gateelektrode dar. Die Emitterzone 1 und die Kollektorkontaktierungszone 13 können als Source- bzw. Drain-Zone verwendet werden. Die Dotierungen der Zonen 3 und 4 können dabei entfallen.

Eine weitgehende Kompatibilität mit der Herstellung eines P-Kanal-Si-Feldeffekttransistors ergibt sich im Hinblick auf die Fig. 15 offensichtlich dadurch, daß die Kontaktierungsöffnung 33 sowie Implantation und Dotierungen der Basiszone entfällt und das Zonen 1 und 13 bei der Implantation der Zone 14 p-leitend dotiert werden.

Die hinsichtlich der Mitintegration von Si-Gate-Transistoren bestehende Kompatibilität des Verfahrens nach der Erfindung bei Verwendung einer Ätzmaskierungsschicht, in die eine Kontaktierungsschicht aus dotiertem polykristallinem Silicium eingebettet wird, wird ergänzt durch die Möglichkeit der Herstellung von ohmschen Widerständen aus dem im Bedarfsfall bahnenförmig in die Ätzmaskierungsschicht 6 eingebetteten polykristallinem Silicium. Deren Widerstandswerte können in weiten Grenzen durch Wahl der Abmessungen der Leitbahnen und selektiven Dotierungen bei den ohnehin erforderlichen Implantationsprozessen eingestellt werden.

**Patentansprüche**

1. Verfahren zum Herstellen einer monolithisch integrierten Festkörperschaltung mit mindestens einem bipolaren Planartransistor, dessen Emitterzone (1) an einer Oberflächenseite eines halbleitenden Substrats (2) an eine Basiszone (3) angrenzt, welche in die Kollektorzone (4) eindiffundiert ist, bei welchem Verfahren

mittels einer ersten maskierten Ionenimplantation die Dotierungen der Kollektorzone (4) innerhalb eines Kollektorbereichs (9) in die Oberflächenseite eingebracht werden,

dann eine den Basisbereich (32) definierende Photolackmaske (5) erzeugt wird,

anschließend in einem zweiten Ionenimplantationsschritt bei relativ geringer Beschleunigungsenergie und relativ hoher Dosis Dotierungsionen vom Leitungstyp der Basiszone (3) und in einem dritten Ionenimplantationsschritt bei relativ großer Beschleunigungsenergie und relativ geringer Dosis Dotierungsionen des gleichen Leitungstyps in den Basisbereich (32) implantiert werden und

anschließend die Dotierungen der Emitterzone (1) mittels einer vierten maskierten Ionenimplantation in den Basisbereich (32) eingebracht und in einem weiteren Schritt die in den Basisbereich (32) und die Emitterzone (1) implantierten Dotierungen eindiffundiert werden, dadurch gekennzeichnet,

daß nach der ersten Ionenimplantation der Kollektorzone (4) ein Diffusionsschritt folgt,

daß anschließend der spätere Emitterbereich (11) mit einem Oxidationsmaskierungsschichtteil (71) bedeckt wird,

daß nach dem Aufbringen der den Basisbereich (32) definierenden Photolackmaske (5) in beliebiger Reihenfolge der zweite oder dritte Ionenimplantationsschritt folgt, wobei der niederenergetische Ionenimplantationsschritt zur Dotierung des freiliegenden äußeren Basiszonenbereichs (31) außerhalb des späteren Emitterbereichs (11) dient und durch den hochenergetischen Ionenimplantationsschritt der gesamte Basiszonenbereich (32) einschießlich des späteren Emitterbereichs (11) dotiert wird,

daß dann nach Entfernung der Photolackmaske (5) der äußere Basisbereich (31) mit einer gegen die Ätzung des Materials des Oxidationsmaskierungsschichtteils (71) widerstandsfähigen Ätzmaskierungsschicht (6) bedeckt wird,

daß sodann der Oxidationsmaskierungsschichtteil (71) durch eine Ätzung entfernt sowie die Dotierungen vom Leitungstyp der Emitterzone (1) implantiert werden und

daß schließlich die Basiszone (3) und die Emitterzone (1) unter Aktivierung ihrer Dotierungen diffundiert werden.

2. Verfahren nach Anspruch 1, dadurch gekennzeichnet, daß eine Oxidationsmaskierungsschicht aus Siliciumnitrid verwendet wird und und die Ätzmaskierungsschicht (6) durch thermische Oxidation der Halbleiteroberfläche des äußeren Basisbereichs (31) erzeugt wird.

3. Verfahren nach Anspruch 2, dadurch gekennzeichnet, daß in die Ätzmaskierungsschicht (6) eine Kontaktierungsschicht (61) aus dotiertem polykristallinem Silicium eingebettet wird, welche die Basiszone (3) oberflächlich kontaktiert.

4. Verfahren nach einem der Ansprüche 1 bis 3, dadurch gekennzeichnet,

daß vor der Diffusion der Kollektorzone (4) der Kollektorbereich (9) eines Substrats (2) aus Silicium mit einer Schicht aus dem Material der Oxidationsmaskierungsschicht (7) bedeckt wird,

daß danach das Substrat (2) um den Kollektorbereich (9) unter Verwendung der Oxidationsmaskierungsschicht (7) als Ätzmaske unter Verwendung eines das Substrat selektiv angreifenden Ätzmittels abgetragen wird,

daß die freiliegende Substratoberfläche thermisch unter Bildung einer Dickoxidschicht (8) oxidiert wird und

daß anschließend aus der den Kollektorbereich (9) bedeckenden Oxidationsmaskierungsschicht (7) der Oxidationsmaskierungsschichtteil (71) ausgeätzt wird.

5. Verfahren nach Anspruch 4, dadurch gekennzeichnet, daß der Oxidationsmaskierungsschichtteil (71) derart ausgeätzt wird, daß sein Rand teilweise entlang des Randes der Dickoxidschicht (8) verläuft.

6. Verfahren nach Anspruch 4 oder 5, dadurch gekennzeichnet, daß die Oxidationsmaskierungsschicht bzw. der Oxidationsmaskierungsschichtteil (7) in einer solchen Dicke und Zusammensetzung auf das Substrat (2) aufgebracht wird, wie es zur Verwendung an einer Si-Gate-elektrode eines Isolierschicht-Feldeffekttransistors erforderlich ist.

7. Verfahren nach Anspruch 6, dadurch gekennzeichnet, daß die Oxidationsmaskierungsschicht (7) außer einer die Basiszone eines bipolaren Planartransistors kontaktierenden Kontaktierungsschicht (61) eine Elektrodenschicht enthält, welche die darunter liegende Substratoberfläche nicht kontaktiert und als Gateelektrode eines Isolierschicht-Feldeffekttransistors verwendet wird, dessen Sourcezonenbereich und dessen Drainzonenbereich gleichzeitig mit dem Emitterzonenbereich des bipolaren Planartransistors dotiert wird.

8. Verfahren nach einem der Ansprüche 1 bis 7, dadurch gekennzeichnet, daß die Basiszonendiffusion und die Emitterzonendiffusion unter einer Fremdoxidschicht (17) durchgeführt werden.

## Claims

1. Process for manufacturing a monolithic integrated solid-state circuit comprising at least one bipolar planar transistor whose emitter region (1), on the surface side of a semiconducting substrate (2), borders on a base region (3) which is diffused into the collector region (4), in which process

with the aid of a first masked ion implantation, the dopings of the collector region (4) within a collector area (9) are introduced into the surface side,

there is then produced a photoresist mask (5) which defines the base area (32),

then, in the course of a second ion implantation step, at a relatively low accelerating energy and in a relatively great dose, doping ions of the same conductivity type as the base region (3) and, in the course of a third ion implantation step, at a relatively high accelerating energy and in a relatively small dose, doping ions of the same conductivity type are implanted into the base area (32), and

after that, the dopings of the emitter region (1) are introduced into the base area (32) in the course of a fourth masked ion implantation and, in the course of a still further step, the dopings as implanted into both the base area (32) and the emitter region (1), are diffused, characterized in

that said first step of implanting ions into the collector region (4) is followed by a diffusion step.

that subsequently the later emitter area (11) is covered with an oxidation masking layer portion,

that after the application of the photoresist mask (5) defining the base area (32) the second or third ion implantation step follows in any optional order of sequence in the course of which the low energetic ion implantation step serves for doping the exposed external base region area (31) outside of the later emitter area (11) and by the high energetic ion implantation step the entire base region area (32) including the later emitter area is doped,

that then, after the removal of said photoresist mask (5) the outer base area (31) is covered with an etch masking layer (6) which is resistant to the etching of the material of the oxidation masking layer portion (71).

that thereafter, the oxidation masking layer portion (71) is removed in the course of an etching process, and that dopings of the conductivity type of the emitter region (1) are implanted, and

that finally, the base region (3) and the emitter region (1) are diffused in response to the dopings being activated.

2. A process as claimed in claim 1, characterized in that an oxidation masking layer of silicon nitride is used, and that the etch masking layer (6) is produced by way of thermal oxidation of the semiconductor surface of the outer base area (31).

3. A process as claimed in claim 2, characterized in that a contacting layer (61) of doped polycrystalline silicon is embedded into said etch masking layer (6), for superficially contacting said base region (3).

4. A process as claimed in one of claims 1 to 3, characterized in

that prior to said diffusion of the collector region (4), the collector area (9) of a substrate (2) of silicon is covered with a layer from the material of the oxidation masking layer (7), and

that thereafter the substrate (2) around the collector area (9) is removed by employing the oxidation masking layer (7) as an etchmask, and by using an etching agent capable of selectively attacking said substrate.

5. A process as claimed in claim 4, characterized in that said oxidation masking layer portion (71) is etched out in such a way that its rim portion will partially extend along the rim portion of said thick oxide layer (8).

6. A process as claimed in claims 4 or 5, characterized in that said oxidation masking layer or said oxidation masking layer portion (7) is deposited in such a thickness and composition on to said substrate (2) as is necessary for being used on a Si-gate electrode of an insulated-gate field-effect transistor.

7. A process as claimed in claim 6, characterized in that said oxidation masking layer (7), besides a contacting layer (61) contacting the base region of a bipolar planar transistor, still contains an electrode layer which not contacts the substrate surface lying there beneath, and is used as the gate electrode of an insulated-gate field-effect transistor whose source region area and whose drain region area are doped simultaneously with the doping of the emitter region area of said bipolar planar transistor.

8. A process as claimed in any one of claims 1 to 7, characterized in that both said base zone diffusion and said emitter zone diffusion processes are carried out below a foreign oxide layer (17).

## Revendications

1. Procédé de fabrication d'un circuit intégré monolithique comprenant au moins un transistor planar bipolaire dont la zone d'émetteur (1), sur la surface d'une face d'un substrat semi-conducteur (2), borde une zone de base (3) qui est diffusée dans une zone de collecteur (4), dans lequel :

par une première implantation ionique masquée, les dopants de la zone de collecteur (4) sont introduits et diffusés par ladite surface dans un domaine de collecteur (9),

ensuite, il est produit un masque en laque photosensible (5) définissant un domaine de base (32),

puis, dans une deuxième étape d'implantation ionique, avec une énergie d'accélération relativement faible et un dosage relativement élevé, sont implantés des ions dopants du type de conductibilité de la zone de base (3) et, dans une troisième étape d'implantation ionique, avec une énergie d'accélération relativement plus forte et un dosage relativement plus faible, sont implantés des ions dopants du même type de conductibilité dans le domaine de base (32) et,

enfin, les dopants de la zone d'émetteur (1) sont introduits dans le domaine de base (32), par une quatrième implantation ionique masquée, et les dopants implantés dans le domaine de base (32) et la zone d'émetteur (1) sont diffusés au cours d'une étape ultérieure, caractérisé en ce que :

après la première implantation ionique de la zone de collecteur (4), suit une étape de diffusion, ensuite, le domaine d'émetteur ultérieur (11) est recouvert d'une partie de couche de masquage d'oxydation (71),

après la réalisation du masque de laque photosensible (5), définissant le domaine de base (32) suit, dans l'ordre voulu, la deuxième ou troisième étape d'implantation ionique, de sorte que l'étape d'implantation ionique à basse énergie sert au dopage du domaine de zone de base externe découvert (31), hors du domaine d'émetteur ultérieur (11) et que, grâce à l'étape d'implantation ionique à haute énergie, l'ensemble du domaine de zone de base (32) incluant le domaine d'émetteur ultérieur (11) est dopé,

puis, après l'enlèvement du masque de laque photosensible (5) le domaine de base externe (31) est recouvert d'une couche de masque d'attaque chimique (6) résistant à l'attaque du matériau de la partie de couche de masquage d'oxydation (71),

après quoi, la partie de couche de masquage d'oxydation (71) est enlevée au cours d'un processus d'attaque et les dopants du type de conductibilité de la zone d'émetteur (1) sont implantés et

finalement, la zone de base (3) et la zone d'émetteur (1) sont diffusés par activation de leurs dopants.

2. Procédé selon la revendication 1, caractérisé en ce que l'on utilise une couche de masquage d'oxydation en nitrure de silicium et en ce que ladite couche de masque d'attaque chimique (6) est produite par oxydation thermique de la surface de semi-conducteur dans le domaine de zone de base externe (31).

3. Procédé selon la revendication 2, caractérisé en ce que, dans la couche de masque d'attaque chimique (6) est incluse une couche de connexion (61) en silicium polycristallin entrant superficiellement en contact avec la zone de base (3).

4. Procédé selon l'une des revendications 1 à 3, caractérisé en ce que :

avant la diffusion de la zone de collecteur (4), le domaine de collecteur (9) d'un substrat (2) de silicium est recouvert d'un matériau d'une couche de masquage d'oxydation (7),

ensuite, le substrat (2) autour du domaine de collecteur (9) est enlevé en employant la couche de masquage d'oxydation (7) comme masque d'attaque et en utilisant un agent d'attaque attaquant sélectivement le substrat,

la surface exposée du substrat est soumise à une oxydation thermique formant une couche d'oxyde épaisse (8), et

enfin, dans cette couche de masquage d'oxydation (7) couvrant le domaine de collecteur, ladite partie de couche de masquage d'oxydation (71) est obtenue par attaque chimique.

5. Procédé selon la revendication 4, caractérisé en ce que ladite partie de couche de masquage d'oxydation (71) est attaquée de manière que son bord s'étende partiellement le long du bord de ladite couche d'oxyde épaisse (8).

6. Procédé selon la revendication 4 ou 5, caractérisée en ce que ladite couche de masquage d'oxydation ou ladite partie de couche de masquage d'oxydation (7) est déposée sur le substrat (2) avec une épaisseur et une composition appropriées pour qu'elle soit utilisée pour une électrode de grille en silicium d'un transistor à effet de champ à grille isolée.

7. Procédé selon la revendication 6, caractérisé en ce que la couche de masquage d'oxydation (7), outre une couche de connexion (61) connectée à la zone de base d'un transistor planar bipolaire, contient aussi une couche d'électrode qui n'est pas en contact avec la surface de substrat sous-jacent à cet endroit et est utilisée comme électrode de grille d'un transistor à effet de champ à grille isolée dont les domaines de source et de drain sont dopés en même temps que le domaine d'émetteur du transistor planar bipolaire.

8. Procédé selon l'une quelconque des revendications 1 à 7, caractérisé en ce que les diffusions de zone de base et de zone d'émetteur ont lieu sous une couche d'oxyde (17) d'origine externe.

FIG. 1

FIG. 2

FIG. 3

FIG. 4

FIG.5

FIG.6

FIG.7

FIG.8

2

FIG. 9

FIG. 10

FIG. 11

FIG. 12

FIG. 13

FIG. 14

FIG. 15

4